# EUROPEAN PATENT SPECIFICATION

(11) **EP 0 521 982 B1**
(45) Date of publication and mention of the grant of the patent: **17.07.1996**
(21) Application number: 91906887.4
(22) Date of filing: 21.03.1991
(51) Int. Cl.: H05K 3/34

(54) **METHOD FOR PRODUCING A PRINTED CIRCUIT BOARD**
VERFAHREN ZUR HERSTELLUNG VON EINER GEDRUCKTEN LEITERPLATTE
PROCEDE POUR LA FABRICATION D'UNE CARTE DE CIRCUIT IMPRIME

(30) Priority: 27.03.1990 GB 9006855
(43) Date of publication of application: 13.01.1993
(73) Proprietor: FERGUSON LIMITED, Enfield, Middlesex, EN1 1ND (GB)
(72) Inventor: ROWE, John Michael, Sha Ha, Sai Kung (HK)
(74) Representative: Einsel, Robert, Dipl.-Ing.
(86) International application number: EP9100547
(87) International publication number: WO9115100

(56) References cited:
- CA-A- 1 197 325
- US-A- 3 610 811
- US-A- 4 851 614
- G. Leonida "Handbook of Printed Circuit Design, Manufacture, Components & Assembly", 1981, Reprinted 1982, Electrochemical Publications Limited, Ayr, Scotland, pages 453 - 454.
- J.A. Scarlett "The multilayer Printed Circuit Board Handbook" 1985, Electrochemical Publications Limited, Ayr, Scotland, page 138.

## Description

The invention concerns a method for producing a printed circuit board (PCB). Within such a method circuit elements like resistors, capacitors, coils and transformers are inserted with their pins into holes of the printed conductors. In a soldering process said pins are soldered to said conductors by a so-called solder wave at the side of the board opposite to the circuit elements.

On the other hand during said soldering process some holes of special conductors are not equipped with circuit elements and are designed for later equipment, especially physically larger components like line transformers, larger capacitors or so on. If the holes are not equipped with circuit elements they would be filled with the solder material by the solder wave so that later insertion of circuit elements is not possible. It would be necessary to blow out the solder material within said holes by special instruments.

According to prior art there is provided between a hole which shall not be filled by solder material during the soldering process and the outer edge of the conductor a break or a slot. The conductor in the region of the hole in this case has a C-like form. Said break or slot within the conductor prevents the soldering material filling the hole during the soldering process. However, this solution requires a special shape of the conductor which can hardly be realized after the conductor has been printed on the circuit board.

Furthermre (A-A-1 197 325 discloses a method for producing a printed circuit board according to the preamble of claim 1.

It is an object of the invention to simplify the means preventing the holes from being filled by the soldering material without using a special form of the conductor.

According to the invention said means include a small solder resisting strip printed upon the conductor diametrically transversing said hole.

It was found out that only by said small solder resisting strip transversing the conductor diametrically to said hole filling of the hole with soldering material can be prevented. Said strip provides a small region at the circumference of the hole wherein the soldering material cannot adhere. Due to this interruption of the copper surface the soldering material cannot fill the hole. This effect results from so-called surface tension. Said surface tension tends to hold together the soldering material at the edge of the hole like a drop of water but prevents it from filling the hole due to said small interruptions. A special size or form of the conductor itself is not necessary. The strip can be provided at any desired hole after the printed circuit board with the conductors of copper has been produced.

When circuit elements are inserted later into said holes not filled with soldering material a normal soldering process by a solder wave or the like can be performed. The small interruptions of said final soldering by said small strips do not significantly effect the electrical conductivity and mechanical stability of the circuit elements fastened with their pins in said holes.

The breadth of the small strips may be in the region of 0,2 to 0,6 mm. They preferably are provided on the copper surface of the conductors by means of a printing process, without covering the holes for the insertion of components.

In order that the invention may be more readily understood, a description is now given by way of example only reference being made to the drawing. Within the drawing
Figure 1 shows an example according to prior art,
Figure 2 a circuit board together with a conductor and the strip designed according to the invention and
Figure 3 a cross sectional view according to line III/III in Fig. 2.

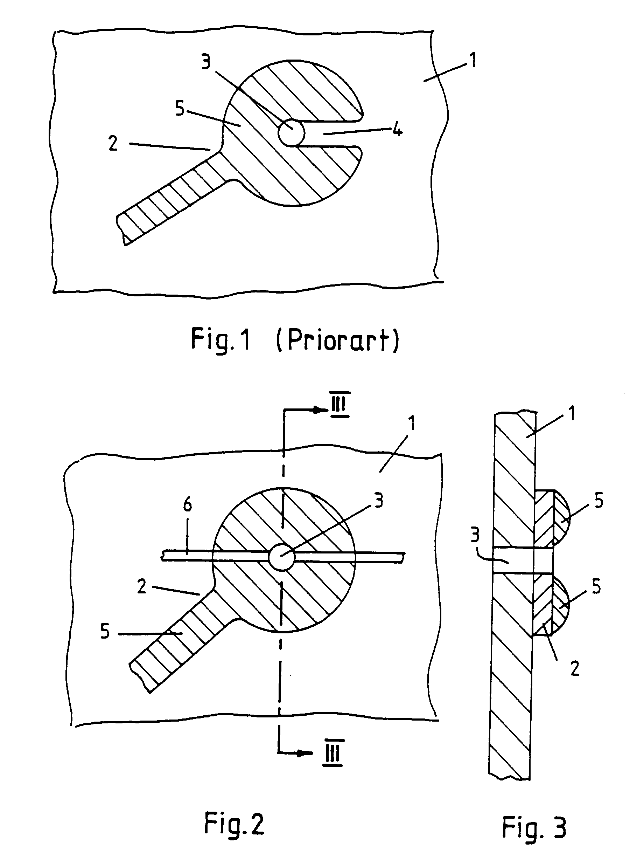

Fig. 1 shows a printed circuit board 1 of any isolating material carrying a printed conductor 2 of copper. The conductor 2 and the board 1 have a hole 3 for insertion of a pin of a circuit element. Between hole 3 and the outer edge of the conductor 2 a break or slot 4 is provided. If the board 1 is fed via a solder wave the soldering material adheres to the surface of the conductor 2. The soldering material however does not fill the hole 3 due to slot 4. So it is possible that after the soldering process has been finished a circuit element can be introduced with its pin into the hole 3 in a further procedure.

In Fig. 2 which shows an embodiment of the present invention the conductor 2 has not a special form. A small thin strip 6 of any solder resisting material is printed on the conductor 2 and the board 1 diametrically transversing the hole 3. Within a first soldering process without any pin of a circuit element within hole 3 the soldering material adheres on the surface of the conductor 2 except the surface of the solder resisting strip 6. Due to the strip 6, therefore, the soldering material does not fill the hole 3 due to the surface tension of the soldering material at the circumference of the hole 3.

If in a later process a circuit element is introduced with its pins into hole 3 a normal soldering connection between said pins and the surface of conductor 2 can be realized except within the small region of strip 6. This small interruption of the soldering connection however does not significantly affect the electrical conductivity between said pins and conductor 2 or the mechanical stability between said circuit element and board 1.

As seen in Fig. 3 the soldering material 5 adheres on the surface of conductor 2. However, the hole 3 transversing board 1 and conductor 2 is not filled with soldering material and remains free for later insertion of the pins of a circuit element. The thin strip 6 is not shown in Fig. 3.

## Claims

1. Method for producing a printed circuit board wherein first circuit elements inserted into first holes of first printed conductors are soldered to said first first conductors by a solder wave and means are provided preventing that second holes of second printed conductors not equipped with a second circuit element are filled by solder, **characterized in that** said means include a small solder resisting strip printed upon the second conductor, said means diametrically transversing said second hole so that, when said second circuit element is later inserted into said second hole, a soldering connection between said second circuit element and said second conductor can be realized except within the region of the small solder resisting strip.

2. Method according to Claim 1, **characterized in that** the breadth of the strip is about 0,2 - 0,6 mm.

## Patentansprüche

1. Verfahren zur Herstellung einer gedruckten Leiterplatte, bei dem erste Schaltungselemente, die in erste Löcher von ersten gedruckten Leitern eingesetzt sind, mit den ersten Leitern durch einen Lötmittelschwall verlötet werden, und bei dem Mittel vorgesehen werden, die verhindern, daß zweite Löcher von zweiten gedruckten Leitern, die nicht mit einem zweiten Schaltungselement bestückt sind, mit Lötmittel gefüllt werden, dadurch gekennzeichnet, daß die Mittel einen kleinen, gegen Lötmittel widerstandsfähigen, auf den zweiten Leiter aufgedruckten Streifen einschließen, wobei die Mittel diametral das zweite Loch kreuzen, so daß, wenn das zweite Schaltungselement später in das zweite Loch eingesetzt wird, eine Lötverbindung zwischen dem zweiten Schaltungselement und dem zweiten Leiter außer in dem Bereich des kleinen gegen Lötmittel widerstandsfähigen Streifens ausgeführt werden kann.

2. Verfahren nach Anspruch 1, dadurch gekennzeichnet, daß die Breite des Streifens etwa 0,2 bis 0,6 mm beträgt.

## Revendications

1. Procédé de fabrication d'une carte à circuit imprimé comportant :
des premiers éléments de circuit insérés dans des premiers trous de premiers conducteurs imprimés qui sont brasés à la vague auxdits premiers conducteurs,
un moyen est prévu pour empêcher que des seconds trous de seconds conducteurs imprimés, non munis d'élément de circuit, soient remplis par le matériau de brasage,
**procédé caractérisé en ce que**
ledit moyen consiste en une bande étroite résistant au brasage imprimé sur le second conducteur, ledit moyen traversant diamétralement ledit second trou, de façon que, lorsqu'un second élément de circuit imprimé est inséré ultérieurement dans ledit second trou, une liaison par brasage entre ledit second élément de circuit et ledit second conducteur puisse être réalisée, à l'exclusion de la zone de ladite bande étroite résistant au brasage.

2. Procédé selon la revendication 1, caractérisé en ce que la largeur de ladite bande est d'environ 0,2 - 0,6 mm.
